Europäisches Patentamt

(19) European Patent Office

Office européen des brevets

(11) Publication number: **0 075 589**

**B 1**

(12) **EUROPEAN PATENT SPECIFICATION**

(45) Date of publication of patent specification: **14.01.87**

(21) Application number: **82901270.7**

(22) Date of filing: **25.03.82**

(86) International application number:
**PCT/US82/00364**

(87) International publication number:
**WO 82/03497 14.10.82 Gazette 82/25**

(51) Int. Cl.⁴: **H 01 L 29/74, H 01 L 27/14, H 01 L 29/747, H 01 L 27/12, H 01 L 27/02, H 01 L 29/06, H 03 K 3/35, H 03 K 17/72**

(54) **GATED DIODE SWITCH.**

(30) Priority: **27.03.81 US 248192**
**27.03.81 US 248206**

(43) Date of publication of application:
**06.04.83 Bulletin 83/14**

(45) Publication of the grant of the patent:
**14.01.87 Bulletin 87/03**

(84) Designated Contracting States:
**BE FR**

(56) References cited:
**WO-A-80/01337**
**US-A-3 657 616**
**US-A-3 870 904**
**US-A-3 911 463**
**US-A-4 016 433**
**US-A-4 060 821**
**US-A-4 146 905**

**1980 ISSCC DIGEST OF TECHNICAL PAPERS, February 1 4, 1980, IEEE, NEW YORK (US) P.W. SHACKLE et al.: "A 500V monolithic bidirectional 2x2 crosspoint array", pages 170-171**

(73) Proprietor: **Western Electric Company, Incorporated**
**222 Broadway**
**New York, NY 10038 (US)**

(72) Inventor: **HARTMAN, Adrian Ralph**
**5 Brook Hollow Lane**
**Murray Hill, NJ 07974 (US)**
Inventor: **RILEY, Terence James**
**1304 Monroe Avenue**
**Wyomissing, PA 19610 (US)**
Inventor: **SHACKLE, Peter William**
**234 Ohio Street**
**West Melborne, FL 32901 (US)**

(74) Representative: **Flechner, Willy et al**
**CABINET FLECHNER 22, Avenue de Friedland**
**F-75008 Paris (FR)**

Courier Press, Leamington Spa, England.

## Description

This invention relates to a structure comprising a semiconductor body whose bulk is of one conductivity type and which has a major surface; a localized first region which is of the one conductivity type; a localized second region which is of the opposite conductivity type; the localized first and second regions being of relatively low resistivity as compared to the bulk of the semiconductor body and separated by a portion of the bulk of the semiconductor body; each of the first and second regions having a portion that forms part of the major surface and having separate electrode coupled thereto; a third region of the opposite conductivity type which is in contact with the semiconductor body and has a separate electrode coupled thereto; the structure being adapted to selectively facilitate current flow between the first and second regions or to divert a sufficient portion of said current into the third region so as to substantially interrupt (cut off) said current flow between the first and second regions, and the third region being separated from the first and second regions by a portion of the bulk of the semiconductor body.

The paper "A 500V Monolithic Bidirectional 2 × 2 Cross Point Array," 1980 ISSCC Digest of Technical Papers, February, 1980, p. 170 describes a high voltage integrated circuit employing a device known as the gated diode switch (GDS), which, because of its high voltage and current handling capability, may be used as a replacement for electromechanical switches, particularly in telephone systems. The GDS comprises anode, cathode and gate regions each included within a dielectrically isolated, lightly doped semiconductor tub. Current between the cathode and anode is switched to the OFF condition by applying an appropriate voltage to the gate which is higher than the anode voltage. This depletes the bulk semiconductor of current carriers between the anode and cathode to cut off conduction.

One problem in the design of the switch is the need for a high voltage on the gate to switch the device off. Also, it would be desirable to provide a switch of this type which has a faster response time. Another problem is that rather complicated control circuits are required for applying the proper gate potential to switch the device.

In accordance with the invention these problems are overcome in a structure of the type described above wherein the characteristics of the bulk portion of the semiconductor body are selected as in the appended claim 1, such that, with the first and third regions held at approximately the same potential, current flow between the first and second regions is substantially inhibited or interrupted, and with the potential of the third region floating or lower than that of the first region, significant current can flow between the first and second regions.

In the drawing:

FIG. 1 is a schematic view of a gated diode switch in accordance with one embodiment of the invention;

FIG. 2 is a schematic top view of a gated diode switch in accordance with another embodiment of the invention;

FIG. 3 is a schematic illustration of a gated diode control circuit in accordance with the invention; and

FIG. 4 is a schematic illustration of a gated diode control circuit in accordance with another embodiment of the invention.

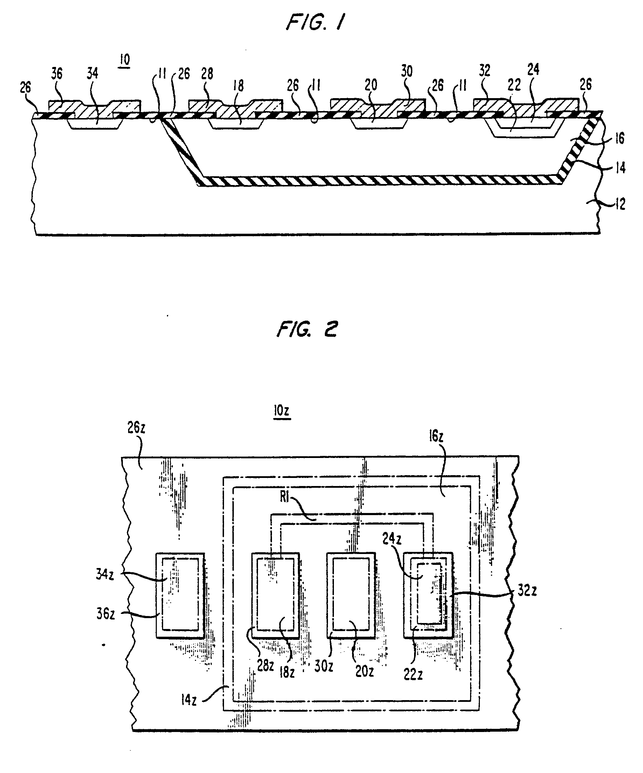

Referring now to FIG. 1, there is illustrated a structure 10 comprising a support member 12 having a major surface 11 and a semiconductor body 16 whose bulk is of one conductivity type and which is separated from support member 12 by an insulator layer 14, which is typically a dielectric layer. The semiconductor body 16 has a portion that is common with surface 11.

A localized first anode region 18, which is of the one type conductivity, is included in body 16 and has a portion thereof that extends to surface 11. A localized second gate region 20, which is of the opposite conductivity, also is included in body 16 and has a portion thereof which extends to surface 11. A localized third cathode region 24, which is of the opposite type conductivity, is included in body 16 and has a portion which extends to surface 11. A region 22, which is of the one type conductivity and has a portion which extends to surface 11, surrounds region 24 and acts as a depletion layer punch-through shield. Region 22 separates cathode region 24 from the bulk portion of semiconductor body 16. In addition it acts to inhibit inversion of the portions of body 16 at or near surface 11 between regions 20 and 24. It also acts to increase the voltage blocking capability between gate region 20 and cathode region 24. Gate region 20 is located between anode region 18 and region 22 and is separated from both by bulk portions of body 16. The resistivities of regions 18, 20, and 24 are low compared to that of the bulk portions of body 16. The resistivity of region 22 is intermediate between that of anode region 18 and that of the bulk portions of body 16.

Electrodes 28, 30, and 34 are conductors which make low resistance contact to the surface portions of regions 18, 20, and 24, respectively. A dielectric layer 26 covers major surface 11 so as to isolate electrodes 28, 30, and 32 from all regions other than those intended to be electrically contacted. An electrode 36 provides a low resistance contact to support 12 by way of a highly doped region 34 which is of the same conductivity type as support 12.

Advantageously, the support 12 and the body 16 are each of silicon and the support 12 may be either of *n* or *p* type conductivity. Each of electrodes 28, 30, and 32 advantageously overlaps the semiconductor region to which they make low resistance contact. Electrode 32 also overlaps region 22. This overlapping, which is known as field plating, facilitates high voltage operation because it increases the voltage at which breakdown occurs.

In one illustrative embodiment, substrate 12 and body 16 and regions 18, 20, 22, 24, and 34 are of $n$, p−, p+, n+, $p$, n+, and n+ type conductivity, respectively. Dielectric layer 14 is silicon dioxide and electrodes 28, 30, 32, and 36 are all aluminum.

A plurality of separate bodies 16 can be formed in a common support 12 to provide a plurality of switches.

Structure 10 is typically operated as a switch having a low impedance path between anode region 18 and cathode region 24 when in the ON state and a high impedance between said two regions when in the OFF (blocking) state. The type of structure described herein is denoted as gated diode switch (GDS). Substrate 12 is typically held at the most positive potential level available when body 16 is of p− type conductivity. It is held at the most negative potential level available when body 16 is of n− type conductivity. With operating potentials applied to the regions 18 and 24, the potential applied to gate region 20 determines the state of the switch. Regions 18 and 24 serve as the anode and cathode regions, respectively, when semiconductor body 16 is of p− type conductivity. Regions 18 and 24 serve as the cathode and anode regions, respectively, when semiconductor body 16 is of n− type conductivity.

With body 16 being of p− type conductivity, conduction between anode region 18 and cathode region 24 is inhibited or interrupted (cut off) if the potential of gate region 20 is sufficiently positive. The amount of positive potential needed to inhibit or interrupt (cut off) conduction is a function of the geometry and impurity concentration (doping) levels of structure 10. This positive gate potential causes a vertical cross-sectional portion of body 16 between gate region 20 and the portion of dielectric layer 14 therebelow to be depleted and the potential of this portion of body 16 to be greater in magnitude than that of anode region 18, cathode region 24, and region 22. This essentially pinches off body 16 against dielectric layer 14 in the bulk portion thereof below gate region 20 and extending down to dielectric layer 14. The positive potential barrier of the aforesaid portion of body 16 is a potential which inhibits conduction of holes from anode region 18 to cathode region 24. If conduction exists between anode region 18 and cathode region 24 before the potential of the gate region 20 is raised to the high potential level, then gate region 20 serves to collect electrons emitted at cathode region 24 before they can reach anode region 18. This serves to help interrupt conduction between anode region 18 and cathode region 24. In addition, the high level potential of gate region 20 serves to cause a vertical cross-sectional portion of body 16 between gate region 20 and the portion of dielectric layer 14 therebelow to be depleted of current carriers. The blocking (essentially nonconducting) state, is the OFF state.

The voltage applied to semiconductor support 12 causes an electric field which extends through dielectric layer 14 and into semiconductor body 16. Normally, during the ON state, electrons coat the bottom of semiconductor body 16 and act to shield it from the effect of the positive bias applied to substrate 12. With structure 10 biased to the OFF state, these electrons are removed from the bottom of semiconductor body 16 and drawn into gate region 20. The biased substrate 12 thus acts as a second or back gate which aids in switching structure 10 to the OFF state.

With semiconductor body 16 being of p− type conductivity, conduction from anode region 18 to cathode region 24 occurs if region 18 is forward-biased with respect to region 24 and the potential of gate region 20 is below a level which inhibits or interrupts conduction between anode region 18 and cathode region 24. During the ON state holes are injected into body 16 from anode region 18 and electrons are injected into body 16 from cathode region 24. These holes and electrons can be in sufficient numbers to form a plasma which conductivity modulates body 16. This effectively lowers the resistance of body 16 such that the resistance between anode region 18 and cathode region 24 is low when structure 10 is operating in the ON state. This type of operation is denoted as dual carrier injection. Positively biased substrate 12 creates an electrical field which passes through the dielectric layer 14 and tends to deplete the bulk portion of body 16. Electrons emitted from cathode region 24 coat the bottom of body 16 and thus act to shield the effect of the electrical field created by biased substrate 12. These electrons invert the bottom of the bulk portion of body 16 which is adjacent dielectric layer 14. This limits the effect of biased substrate 12 and thus allows conduction between anode region 18 and cathode region 24 in the ON state.

Region 22 helps limit the punch-through of a depletion layer formed during operation between gate region 20 and cathode region 24 and helps inhibit formation of a surface inversion layer between these two regions. In addition, it permits gate region 20 and cathode region 24 to be relatively closely spaced. This facilitates relatively low resistance between anode region 18 and cathode region 24 during the ON state. It also serves to increase maximum operating voltage and to reduce leakage currents.

During the ON state of structure 10, the junction diode comprising semiconductor body 16 and gate region 20 can become forward-biased. Current limiting means (not illustrated) are normally included to limit the conduction through the forward-biased diode.

The ON state can be achieved by having the potential of the anode region 18 greater than that of the cathode region 24 and forward-biasing the anode region 18 with respect to the gate region 20. Typically, 1—10 microamperes are extracted from the gate region 20 while the anode-gate junction is forward-biased to cause structure 10 to assume the ON state.

It is possible to operate structure 10 in the ON state with the potential of gate region 20 at the same or a more positive level than that of anode region 18, cathode region 24, and region 22, so long as the potential of gate region 20 is below a level which essentially completely depletes a vertical cross-sectional portion of semiconductor body 16 between anode region 18 and cathode region 24. With the gate region 20 held at such a potential level, the junction diode comprising semiconductor body 16 and gate region 20 has a zero forward bias or is reverse-biased.

It has been discovered that decreasing the impurity concentration of the bulk portion of semiconductor body 16 of structure 10 of FIG. 1 causes a modification in the mode of operation. Starting with known design parameters, but with the impurity concentration of the bulk of semiconductor body 16 at approximately $1 \times 10^{13}$ instead of a conventional quantity such as $9 \times 10^{13}$ impurities/cm$^3$, it has been found that with the gate region 20 at approximately the same voltage as anode region 18, conduction between anode region 18 and cathode region 24 is inhibited or interrupted (cut off) except for a relatively low level flow. This is the OFF (high impedance) state. With a positive bias applied to anode region 18 relative to cathode region 24, and with gate region 20 allowed to essentially electrically float in potential, substantial current can flow between anode region 18 and cathode region 24. This is the ON (low impedance) state. The relatively low level current flow of the OFF state helps in switching structure 10 to the ON state.

One major advantage of structure 10, which has a semiconductor body 16 whose impurity concentration is as described immediately hereinabove, is that the gate potential need only be at that of the anode potential to switch the structure to the OFF state. It is thus not necessary to use a higher potential than exists at the anode in order to operate structure 10, which considerably simplifies power supply problems and circuit design. Many applications require high voltage and high current switches but the most positive potential available is that applied to one of the terminals of the switch.

Referring now to FIG. 2, there is illustrated a top view of a structure 10z which is very similar to structure 10 of FIG. 1 and all components thereof which are essentially identical or similar to structure 10 are denoted with the same reference number with the addition of an "z". The basic difference between structures 10z and 10 is the inclusion of a resistive-type region R1 in structure 10z which couples anode region 18z to shield region 22z. The inclusion of region R1 gives a dependably high turn-on speed and allows for a considerably wider variation in the impurity concentration of semiconductor region 16z than is possible if R1 is not utilized. R1 serves to provide a predictable high impedance path between anode region 18z and shield region 22z during the OFF state. Variations in the impurity concentration of semiconductor body 16z thus become less critical since a high impedance path is established between anode region 18z and shield region 22z and this path exists relatively independ-

dently of the impurity concentration of semiconductor body 16z. Typically, the impurity concentration of semiconductor body 16z is between $2 \times 10^{12}$ impurities/cm$^3$ and $2 \times 10^{13}$ impurities/cm$^3$. R1 can be ion implanted or diffused into semiconductor body 16z. A discrete resistor could be connected between anode electrode 28z and region 22z, provided an electrode (not illustrated) is provided which is in contact with region 22z. This resistor would serve essentially the same purpose as R1; that is, it would conduct a small current during the OFF state to increase switching speed when the device is turned ON. In a preferred embodiment, R1 is an ion implanted pinch type resistor, of the same conductivity type as regions 18z and 22z and is ion implanted with a dose of $10^{11}$—$10^{13}$ impurities/cm$^2$. Region 22z can be eliminated in some application, in which case R1 is extended so as to contact cathode region 24z.

Support member 12 may be an $n$ type monocrystalline silicon substrate, 18 to 22 mils (1 mil = .00254 mm) thick, with an impurity concentration of approximately $1 \times 10^{13}$ impurities/cm$^3$. Dielectric layer 14 is a silicon dioxide layer that is 2 to 4 microns thick. Body 16 is typically 35 to 65 microns thick, approximately 430 microns long, 300 microns wide, and is of $p$ type conductivity with an impurity concentration in the range of approximately $5$—$9 \times 10^{13}$ impurities/cm$^3$. Anode region 18 is of p+ type conductivity, is typically 2 to 4 microns thick, 44 microns wide, 52 microns long, and has an impurity concentration of approximately $10^{19}$ impurities/cm$^3$. Electrode 28 is typically aluminum, with a thickness of $1\frac{1}{2}$ microns, a width of 84 microns, and a length of 105 microns. Region 20 is of n+ type conducitvty and is typically 2 to 30 microns thick, 15 microns wide, 300 microns long, and has an impurity concentration of approximately $10^{19}$ impurities/cm$^3$. The depth of region 20 is determined by the thickness of body 16. Electrode 30 is aluminum, $1\frac{1}{2}$ microns thick, 50 microns wide, and 210 microns long. The spacing between adjacent edges of electrodes 28 and 30 and between adjacent edges of electrodes 30 and 32 is typically 40 microns in both cases. Region 22 is $p$ type conductivity and is typically $3$—$6$ microns thick, 64 microns wide, 60 microns long, and has an impurity concentration of approximately $10^{17}$ to $5 \times 10^{18}$ impurities/cm$^3$. Cathode region 24 is n+ type conductivity and is typically $2$—$4$ microns thick, 49 microns wide, 44 microns long, and has an impurity concentration of approximately $10^{19}$ impurities/cm$^3$. Electrode 32 is aluminum, $1\frac{1}{2}$ microns thick, 104 microns wide, and 104 microns long. The spacing between the ends of regions 18 and 22 and the respective ends of region 16 is typically 55 microns. Region 34 is n+ type conductivity and is typically 2 microns thick, 26 microns wide, 26 microns long, and has an impurity concentration of $10^{19}$ impurities/cm$^3$. Electrode 36 is aluminum which is $1\frac{1}{2}$ microns thick, 26 microns wide, and 26 microns long. Insulating (dielectric) layer 26 is typically 3—5 microns thick. Resistor R1 may be 10—30 microns wide, 200—300 microns long with a sheet resistance of 2—200 kilohms per square, a resistance of 40 kilohms to 4 megaohms, a junction depth of 5—6 microns and a pinch-off current of .1 microamp to 10 microamps.

Structure 10, using the parameters denoted above, may be operated as a gated diode switch (GDS) with 500 volts between anode and cathode. A layer of silicon nitride (not illustrated) may be deposited by chemical vapor deposition on top of silicon dioxide layer 26 to provide a sodium barrier. Electrodes 28, 30, 32, and 36 may then be formed and thereafter a coating of radio frequency plasma deposited silicon nitride (not illustrated) applied to the entire surface of structure 10 except where electrical contact is made. The layers of silicon nitride serve to help prevent high voltage breakdown in the air between adjacent electrodes.

Typically the anode has +250 volts applied thereto, the cathode −250 volts applied thereto, and substrate 12 has +250 volts applied thereto. The −250 volts can also be applied to the anode and the +250 volts applied to the cathode without damage to structure 10. The anode and cathode remain essentially electrically isolated from each other and there is little or no current flow between anode and cathode. Thus, structure 10 bilaterally blocks voltage between anode and cathode. A potential of +250 volts applied to gate electrode 30 will interrupt or break 350 mA of current flow between anode region 18 and cathode region 24. When the potential of the gate electrode 30 is switched from the anode voltage to essentially one junction voltage drop below the potential of the anode, the GDS switches from the OFF state to the ON state. The ON resistance of the GDS with 100 mA flowing between anode and cathode is approximately 15 ohms and the voltage drop between anode and cathode is typically 2.2 volts.

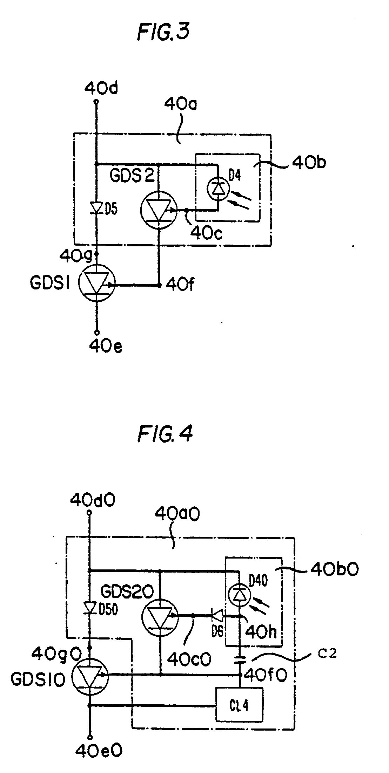

From the foregoing it can be appreciated that a GDS made in accordance with the invention will simplify the problems of providing appropriate power supplies. Switching can be made at a relatively high speed. The advantages of simplified control circuitry are illustrated in FIG. 3 which shows how a low power light source can be used in a simple manner to control a GDS so as to switch relatively high voltages and currents.

Referring now to FIG. 3, there is illustrated control circuitry 40a (illustrated within the larger dashed line rectangle) which is coupled to a high voltage and current switch GDS1 which has anode, cathode, and gate terminals 40g, 40e, and 40f, respectively. GDS1 is assumed to be a switch of the type illustrated in FIG. 1 with the impurity concentration of semiconductor body 16 being selected such that GDS1 can be switched to an off (high impedance) state by coupling the gate terminal thereof to a potential whose magnitude is close to that applied to the anode. Control circuitry 40a comprises a photodiode D4, a diode D5, and a high voltage current switch GDS2 which is of the same type as GDS1. D4 is illustrated within dashed line rectangle 40b and may be denoted as a voltage control branch circuit or simply as a branch circuit. The anode of D4 is coupled to the gate of GDS2 and to a terminal 40c. The cathode of D4 is coupled to the anodes of GDS2 and D5, and to a terminal 40d. The cathode of D5 is coupled to the anode of GDS1 and to terminal 40g. The cathode of GDS2 is coupled to the gate of GDS1 and to terminal 40f.

Control circuitry 40a is adapted to selectively set the potential of the terminal 40f (the gate of GDS1) to a value close to that of the anode of GDS1 (terminal 40g) or to allow terminal 40f to essentially electrically float in potential. Assume a positive potential of sufficient magnitude to forward bias D5 and GDS1 is applied to terminal 40d with respect to terminal 40e. If terminal 40f electrically floats in potential, then GDS1 is ON and conduction will occur between terminals 40d and 40e.

Photodiode D4 acts as a battery when light is incident thereon. As such it sets the potential of terminal 40c (the gate of GDS2) at approximately +0.7 V above that of terminal 40d. This sets GDS2 to an OFF state and thus isolates terminal 40f from terminal 40d by the high impedance of the anode-cathode of GDS2. Thus terminal 40f of GDS1 essentially electrically floats in potential. This sets GDS1 to an ON state and conduction occurs between terminals 40d and 40e.

D4 acts to isolate terminals 40d and 40c when there is no light incident thereon since the "dark" resistance of D4 is large. The gate of GDS2 (terminal 40c) electrically floats in potential and thereby sets GDS2 to an ON state. Any positive potential applied to terminal 40d is thus applied through the relatively low ON impedance of GDS2 to terminal 40f. Accordingly, terminal 40f assumes a potential of approximately one diode voltage drop (the voltage across the anode-cathode of GDS2) below that of terminal 40d. The potential of the anode of GDS1 (terminal 40g) is likewise one diode voltage (the voltage across D5) below terminal 40d. Since the anode and gate terminals of GDS1 are essentially at the same potential, GDS1 is switched to an OFF state. This leaves terminals 40d and 40e separated by the relatively high impedance of switched OFF GDS1.

Now referring to FIG. 4, there is illustrated control circuitry 40a0 (illustrated within the larger dashed line rectangle) which is coupled to a high voltage and current switch GDS10 which has anode, cathode, and gate terminals 40g0, 40e0, and 40f0, respectively. Control circuitry 40a0 is very similar to control circuitry 40a of FIG. 3 and all components and terminals which are similar or identical have reference numerals which are the same as the reference numerals of the corresponding components and terminals of FIG. 3 with an added "0" at the end. The basic difference between control circuitry 40a0 and 40a is the inclusion of a diode D6, a capacitor circuit means C2 (typically referred to as a capacitor), and a current limiter circuit CL4. The anode of D6 is coupled to the anode of D40, a first terminal of C2, and to a terminal 40h. The cathode of D6 is coupled to terminal 40c0 and to the gate terminal of GDS20. A second terminal of C2 is coupled to terminal 40f0 and to CL4. CL4 is also coupled to the cathode of GDS10 and to terminal 40e0.

Without D6 reverse current can flow from terminal 40e0, through the cathode-gate terminals of GDS10 and GDS20, and then through D40 and into terminal 40d0. D6 serves to block this electrical path such that the combination of GDS10 and control circuitry 40a0 selectively blocks the flow of substantial current from terminal 40d0 to 40e0 or vice versa.

CL4 is typically a pinch resistor which bleeds off the low current through GDS20 which exists when GDS20 is in an OFF state. With light incident upon D40, GDS20 is in an OFF state. The low level of current passing through the anode-cathode of GDS20 could raise the potential of terminal 40f0 sufficiently to cause GDS10 to be maintained in the OFF state. CL4 serves to effectively lower the potential of terminal 40f0 such that GDS10 is switched to the ON state when light is incident upn D40.

C2 is used to decrease sensitivity to voltage transients that may appear at terminal 40d0. A positive going voltage pulse applied to terminal 40d0 is transmitted through the parasitic capacitance (not illustrated) of D40 and through D6 and the parasitic capacitance (not illustrated) thereof. This increases the potential of the gate (terminal 40c0) of GDS20 and can turn off GDS20 and thus allow GDS10 to turn ON and conduct substantial current even though it is supposed to be OFF since there is no illumination on D40. C2 acts to limit the magnitude of the voltage transient and to dissipate the resulting current flow relatively rapidly. The parasitic capacitance (not illustrated) of the gate-cathode junction of GDS20 can be increased relative to the parasitic capacitance of D4 to effect the same result as C2. Alternately, the parasitic capacitance of D40 can be decreased relative to that of the parasitic capacitance of the gate-cathode junction of GDS20 to effect the same result. In both cases C2 can be eliminated.

The combination of GDS10 and control circuitry 40a0 functions as a unidirectional relay which is controlled by a light signal. Two of such configurations can be coupled together with terminals 40d0 and 40e0, and 40f0 of the first coupled to terminals 40e0, 40d0, and 40f0, respectively, of the second. This results in a bidirectional relay which is controlled by light signals.

The invention may be used, within the scope defined by the appended claims, in conjunction with many embodiments of the gated diode switch other than those shown. For example, the invention may be used in conjunction with any of the gated diode switch embodiments described in the PCT application of Western Electric Co., International Publication No. WO 80/01337, 26 June 1980.

**Claims**

1. A switching device comprising a semiconductor body (16) whose bulk is of one conductivity type and which has a major surface; said body (16) being disposed on a semiconductor substrate (12) and being separated therefrom by an intervening layer (14) of a dielectric material, an electrode (36) contacting said substrate (12), said body (16) including a localized first region (18) which is of the one conductivity type and a localized second region (24) which is of the opposite conductivity type; and localized first and second regions (18, 24) being of relatively low resistivity as compared to the bulk of the semiconductor body (16) and separated from each other and said layer (14) by portions of the bulk of the semiconductor body (16); each of the first and second regions (18, 24) having a portion that forms part of the major surface and having a separate electrode (28, 32) coupled thereto; a third region (20) of the opposite conductivity type forming part of the major surface in contact with the semiconductor body (16) and having a separate electrode (30) coupled thereto; the third region (20) being disposed between the first and second regions (18, 24) and separated therefrom and from said layer (14) by portions of the bulk of the semiconductor body (16); the structure being adapted to selectively facilitate current flow below the first and second regions (18, 24) or to divert a sufficient portion of said current into the third region (20) so as to substantially interrupt said current flow between the first and second regions (18, 24); characterized in that the bulk portion of the semiconductor body (16) has an impurity concentration of $2 \times 10^{12}$ to $2 \times 10^{13}$ impurities/cm$^3$, resulting in such characteristics that, with the first and third regions (18, 20) held at approximately the same potential, current flow between the first and second regions (18, 24) is substantially inhibited.

2. The device of claim 1 further characterized in that a resistive path (R1) interconnects the first and second regions.

3. The structure of claim 2 further characterized in that the resistive path has a resistance 40 kilohms to 4 megaohms.

4. The device of claim 3 further characterized in that the resistive path is a path ion implanted on the surface of the bulk portion with a pinch-off current of .1 microamp to 10 microamps.

5. The device of claim 1 further characterized in that an output terminal (40f) of a gated diode switch (GDS2) is connected to the third region (20) and a branch circuit (40b) controls conduction in the gated diode switch.

6. The circuitry of claim 5 further characterized by the first diode (D5) having a first terminal coupled to a first output terminal (40g) of the gated diode switch and having a second terminal coupled to a first output terminal of the switching device.

7. The circuitry of claim 6 further characterized in that the branch circuit comprises a second diode D4 which is a photo-diode and which has a first terminal coupled to the control terminal of the gated diode switch and which has a second terminal coupled to an output terminal of the switching device and to a terminal of the first diode (D5).

8. The circuitry of claim 7 further characterized in that a third diode D6 has an anode terminal coupled to the anode terminal of the second diode (D40) and a cathode terminal coupled to the control terminal of the gated diode switch (GDS20).

## Patentansprüche

1. Schaltendes Bauelement mit einem Halbleiterkörper (16), der in seinem Volumen vom einen Leitungstyp ist und eine Hauptfläche besitzt,

— wobei der Körper (16) auf einem Halbleitersubstrat (12) angeordnet und von diesem durch eine zwischenliegende Schicht (14) aus einem dielektrischen Material getrennt ist, eine Elektrode (36) das Substrat (12) kontaktiert, der Körper (16) eine lokalisierte erste Zone (18) des einen Leitungstyps und eine lokalisierte zweite Zone (24) des entgegengesetzten Leitungstyps aufweist,

— wobei die lokalisierte erste und zweite Zone (18, 24) einen im Vergleich zum Volumen des Halbleiterkörpers (16) relativ niedrigen spezifischen Widerstand besitzen und voneinander sowie von der Schicht (14) durch Teile des Volumens des Halbleiterkörpers (16) getrennt sind,

— wobei die erste und zweite Zone (18, 24) je einen Teil, der einen Teil der Hauptfläche bildet, und eine hieran angekoppelte getrennte Elektrode (28, 32) besitzen,

— wobei eine dritte Zone (20) des entgegengesetzten Leitungstyps einen Teil der Hauptfläche in Kontakt mit dem Halbleiterkörper (16) bildet und eine getrennte Elektrode (30) hieran angekoppelt hat,

— wobei die dritte Zone (20) zwischen der ersten und der zweiten Zone (18, 24) angeordnet und hiervon und von der Schicht (14) durch Teile des Volumens des Halbleiterkörpers (16) getrennt ist,

— wobei die Struktur dafür ausgelegt ist, selektiv einen Stromfluß zwischen der ersten und der zweiten Zone (18, 24) zu ermöglichen oder einen ausreichenden Teil des Stroms in die dritte Zone (20) abzuleiten, um im wesentlichen des Stromfluß zwischen der ersten und zweiten Zone (18, 24) zu unterbrechen, dadurch gekennzeichnet, daß der Volumteil des Halbleiterkörpers (16) eine Fremdstoffkonzentration von $2 \times 10^{12}$ bis $2 \times 10^{13}$ Fremdstoffe/cm³ hat, die zu Eigenschaften führt derart, daß bei auf annähernd gleichem Potential gehaltener erster und dritter Zone (18, 20) der Stromfluß zwischen der ersten und der zweiten Zone (18, 24) im wesentlichen blockiert ist.

2. Bauelement nach Anspruch 1, des weiteren dadurch gekennzeichnet, daß ein Widerstandsweg (R1) die erste und zweite Zone verbindet.

3. Struktur nach Anspruch 2, des weiteren dadurch gekennzeichnet, daß der Widerstandsweg einen Widerstand von 40 Kiloohm bis 4 Megaohm besitzt.

4. Bauelement nach Anspruch 3, des weiteren dadurch gekennzeichnet, daß der Widerstandsweg ein ionenimplantierter Weg auf der Oberfläche des Volumteils mit einem Abschnürstrom von 0,1 bis 10 Mikroampere ist.

5. Bauelement nach Anspruch 1, des weiteren dadurch gekennzeichnet, daß ein Ausgangsanschluß (40f) eines gategesteuerten Diodenschalters (GDS2) mit der dritten Zone (20) verbunden ist und eine Zweigschaltung (40b) die Leitung in dem gategesteuerten Diodenschalter steuert.

6. Schaltung nach Anspruch 5, des weiteren dadurch gekennzeichnet, daß die erste Diode (D5) einen ersten Anschluß, der mit einem ersten Ausgangsanschluß (40g) des gategesteuerten Diodenschalters gekoppelt ist, und einen zweiten Anschluß, der mit einem ersten Ausgangsanschluß des schaltenden Bauelementes gekoppelt ist, besitzt.

7. Schaltung nach Anspruch 6, des weiteren dadurch gekennzeichnet, daß die Zweigschaltung eine zweite Diode (D4) besitzt, die eine Fotodiode ist und einen ersten Anschluß, der mit dem Steueranschluß des gategesteuerten Diodenschalters gekoppelt ist, und einen zweiten Anschluß, der mit einem Ausgangsanschluß des schaltenden Bauelementes und mit einem Anschluß der ersten Diode (D5) gekoppelt ist, besitzt.

8. Schaltung nach Anspruch 7, des weiteren dadurch gekennzeichnet, daß eine dritte Diode (D6) einen Anodenanschluß, der mit dem Anodenanschluß der zweiten Diode (D40) gekoppelt ist, und einen Kathodenanschluß, der mit dem Steueranschluß des gategesteuerten Schalters (GDS20) gekoppelt ist, besitzt.

## Revendications

1. Un dispositif de commutation comprenant un bloc de semiconducteur (16) dont le volume principal est d'un premier type de conductivité et qui a une surface principale; ce bloc (16) étant disposé sur un substrat semiconducteur (12) et étant séparé de ce dernier par une couche intercalée (14) d'une matière diélectrique, une électrode (36) en contact avec le substrat (12), ce bloc (16) comprenant une première région localisée (18) qui est du premier type de conductivité, et une seconde région localisée (24) qui est du type de conductivité opposé; les première et seconde régions localisées (18, 24) ayant une résistivité relativement faible comparée à celle du volume principal du bloc de semiconducteur (16) et étant séparées mutuellement et par rapport à la couche précitée (14) par des parties du volume principal du bloc de semiconducteur (16); chacune des première et seconde régions (18, 24) ayant une partie qui appartient à la surface principale et à laquelle est connectée une électrode séparée (28, 32); une troisième région (20) du type de conductivité opposé, faisant partie de la surface principale en contact avec le bloc de semiconducteur (16), et à laquelle est connectée une électrode séparée (30); la troisième région (20) étant disposée entre les première et seconde régions (18, 24) et étant séparée de celles-ci et de la couche précitée (14) par des parties du volume principal du bloc de semiconducteur (16); la structure étant conçue de façon à accomplir sélectivement les opérations qui consistent à faciliter la circulation du courant entre les première et seconde régions (18, 24) ou à dériver une partie suffisante de ce courant vers la troisième région (20), de façon à interrompre pratiquement la circulation du courant entre les première et seconde régions (18, 24); caracterise en ce que la partie de volume principal du bloc de semiconducteur (16) a une concentration en impuretés de $2 \times 10^{12}$ à $2 \times 10^{13}$ impuretés/cm$^3$, ce qui donne des caractéristiques telles que, lorsque les première et troisième régions (18, 20) sont maintenues approximativement au même potentiel, la circulation du courant entre les première et seconde régions (18, 24) est pratiquement bloquée.

2. Le dispositif de la revendication 1 caracterise en outre en ce que un chemin résistif (R1) interconnecte les première et seconde régions.

3. La structure de la revendication 2 caracterise en outre en ce que le chemin résistif à une résistance de 40 kiloohms à 4 mégohms.

4. Le dispositif de la revendication 3 caracterise en outre en ce que le chemin résistif est un chemin formé par implantation ionique sur la surface de la partie de volume principal, avec un courant de pincement de 0,1 microampère à 10 microampères.

5. Le dispositif de la revendication 2 caracterise en outre en ce que une borne de sortie (40f) d'un élément de commutation à diode commandée (GDS2) est connectée à la troisième région (20) et un circuit de dérivation (40b) commande la conduction dans l'élément de commutation à diode commandée.

6. Le circuit de la revendication 5 caracterise en outre en ce que la première diode (D5) comporte une première borne connectée à une première borne de sortie (40g) de l'élément de commutation à diode commandée, et elle comporte une seconde borne connectée à une première borne de sortie du dispositif de commutation.

7. Le circuit de la revendication 6 caracterise en outre en ce que le circuit de dérivation comprend une seconde diode (D4) qui est une photodiode et qui comporte une première borne connectée à la borne de commande de l'élément de commutation à diode commandée, et une seconde borne connectée à une borne de sortie du dispositif de commutation et à une borne de la première diode (D5).

8. Le circuit de la revendication 7 caracterise en outre en ce que une troisième diode (D6) comporte une borne d'anode connectée à la borne d'anode de la seconde diode (D40) et une borne de cathode connectée à la borne de commande de l'élément de commutation à diode commandée (GDS20).

## FIG. 1

## FIG. 2

FIG.3

FIG.4

2